# EUROPEAN PATENT SPECIFICATION

(11) **EP 1 953 117 B1**
(45) Date of publication and mention of the grant of the patent: **30.06.2010**
(21) Application number: 06817636.1
(22) Date of filing: 02.11.2006
(51) Int. Cl.: B82B 3/00, G03F 7/20, G03F 1/00, G03F 7/00

(54) **SCANNING JET NANOLITHOGRAPH AND THE OPERATION METHOD THEREOF**
NANOLITHOGRAPHIEVORRICHTUNG MIT ABTASTSTRAHL UND BETRIEBSVERFAHREN DAFÜR
APPAREIL DE NANO-LITHOGRAPHIE A BALAYAGE A JETS ET PROCEDE DE FONCTIONNEMENT

(30) Priority: 02.11.2005 BY 20051057
(43) Date of publication of application: 06.08.2008
(73) Proprietor: Ilyanok, Alexander Mikhailovich, Minsk, 220007 (BY)
(72) Inventor: TIMOSHCHENKO, Igor Andreevich, Minsk, 220007 (BY)
(74) Representative: Sloboshanin, Sergej
(86) International application number: PCT/BY2006/000007
(87) International publication number: WO 2007/051274

(56) References cited:
- WO-A-01/71778
- WO-A1-01/24219
- JP-A- 2005 159 358
- RU-C2- 2 175 761
- US-A1- 2003 007 242
- VOIGT J ET AL: "Nanofabrication with scanning nanonozzle 'Nanojet'" MICROELECTRONIC ENGINEERING, ELSEVIER PUBLISHERS BV., AMSTERDAM, NL, vol. 57-58, 1 September 2001 (2001-09-01), pages 1035-1042, XP004302380 ISSN: 0167-9317
- RANGELOW ET AL.: ""NANOJET": Tool for the nanofabrication" J.VAC.SCI.TECHNOL.B., [Online] vol. 19, no. 6, November 2001 (2001-11), pages 2723-2726, XP002501360 Retrieved from the Internet: URL:http://scitation.aip.org/getpdf/servle t/GetPDFServlet?filetype=pdf&id=JVTBD90000 19000006002723000001&idtype=cvips> [retrieved on 2008-10-24]
- ZHANG L B ET AL: "THE ADVANCEMENT OF SPM-BASED NANOLITHOGRAPHY" MATERIALS SCIENCE FORUM, AEDERMANNSFDORF, CH, vol. 471-472, 1 January 2004 (2004-01-01), pages 353-357, XP008070443 ISSN: 0255-5476
- COOK R.J.; BERNHARDT A.F.: 'Deflection of atoms by a resonant standing electromagnetic wave' PHYSICAL REVIEW A, [Online] vol. 18, no. 6, December 1978, pages 2533 - 2537 Retrieved from the Internet: <URL:http://prola.aps.org/pdf/PRA/v18/i6/p2 533_1> [retrieved on 2009-12-17]
- NEBENZAHL I.; SZÖKE A.: 'Deflection of atomic beams by resonance radiation using stimulated emission' APPLIED PHYSICS LETTERS, [Online] vol. 25, no. 6, 15 September 1974, pages 327 - 329 Retrieved from the Internet: <URL:http://scitation.aip.org/getpdf/servle t/GetPDFServlet?filetype=pdf&id=APPLAB00002 5000006000327000001&idtype=cvips&prog=norma l> [retrieved on 2009-12-17]

## Description

### Field of the invention.

The invention relates to a scanning jet nanolitograph according to the preamble of claim 1, and more specifically to the field of the manufacturing equipment for the electronic industry and can be used in the production of integrated circuits with nanoscaled elements, and can simultaneously realize operations of the monitoring of nanolithography process and operations of the contour cutting of materials, forming atomic smooth surfaces.

### Background of the invention.

It is known that in the present time the electronic industry for the mainstream production of planar very large-scale integrated circuits (very large IC) having 10⁷-10⁸ active elements (transistors) per crystal uses lithographic installations with resolution 65-100 nm. A resolution is obtained due to using of excimer lasers ArF with wavelength 193 nm, phase-contrast transparent patterns and special photoresists [1]. A wave nature of processes and a possibility of the parallel transfer of the whole figure of an integrated circuit or its part on a semiconductor part of a substrate leads to the fact that a photolithography will be used until exhausting of its potentialities. A subsequent decreasing of laser wavelength is connected with a problem of existence in the nature necessary optically transparent materials for photo masks. This forces to change refracting optics to reflecting ones and to use electron or ion beams instead of electromagnetic radiation sources.

Today there are four ways to obtain the integrated circuits with a resolution less than 65 nm. They are an extreme ultra violet lithography (EUVL), an electron projection lithography (SCALPEL), a X-ray lithography and an ion beam lithography. Attempts to improve a serial lithography of near ultraviolet 193 nm by an immersion method have allowed reaching a fundamental limit for this technology, namely 45 nm ("ASML" TWINSCAN XT: 1700i). The X-ray lithography uses photons with high energy more than 100 eV that decreases the resolution due to forming of high-energy secondary electrons. For the present time EUVL is considered to be suitable for the serial production with the resolution equal 6,5 - 35 nm only. But EUVL has a very high factor of energy losses, because of a low efficiency of a transformation of the electrical energy in extreme ultraviolet and a high factor of losses in a reflection optics system. Besides the low factor of the conversion the nanolithograph, consists of a great number of other causes of energy losses (table 1).

Table 1. Levels of an electrical and an optical power in different units of EUVL nanolithograph at the productivity corresponding to one of modern scanner/stepper ASML (TWINSCAN AT: 1200 B) and at the resist sensitivity 5mJ/cm² [1]_{.}

| Photoresist sensitivity **mJ/cm²** | Exposure power for 100 substrate/h (∅300nm), | Total radiation power at a mask surface, **W** *P_{M}* | | Collected radiation power from a source | Total source radiation power | Total primary source radiation power** | Total electrical power*** **kW** *P₁* |
|---|---|---|---|---|---|---|---|
| *S* | **W** *P* | | | **EUV,W** *Pₐ* | **EUV, W** *P*_{*2*π} | **kW** *P₁₀* | |
| 5 | 2.68* | *2M* | 9.8 | 77 | 310 | 15 | 150 |
| | | *4M* | 23 | 183 | 734 | 37 | 370 |
| | | *6M* | 55 | 4341027 | 1736 | 87 | 870 |
| | | *8M* | 130 | | 4110 | 205 | 2050 |

*Losses of time at the rate of 50% between exposures are taken into consideration, all power values increase in 10 times because of losses of time at scanning,** conversion ratio η=2%, ***laser efficiency ηₑ=10%.

Parallel projecting lithography technologies such as an electron and an ion beam lithography with use of wide beams face difficulties of problems of an emissive or a transparent pattern, which practically cannot be solved at the manufacture level. Such a pattern contains a small figure (a fragment) and allows transferring it at a time. However, the pattern has to be transparent for the electron (the ion) beam. Today, there are extremely complicated and expensive devices and technologies (e.g., SCALPEL, the transparent electron pattern width is about 100 nm). They can exposure a more or less modern very large IC in an acceptable time. The sequential electron and the ion beam lithography with use of the narrow scanning beam are applicable because of the low productivity for forming of the master pattern for EUVL only.

Thus, without providing of a cheap powerful ultraviolet radiation source having the wavelength range 13.5 nm, a solution of a problem of serial EUVL production with a reasonable productivity is impossible. According to the forecasts, a manufactory using such a work cycle can cost tens billions of dollars in whole. All this pushes to look for providing of principal new ways and methods of the nanolithography.

One of the ways is a proposal of the HP corporation to use not photo methods, but imprint lithography methods with the help of nanomatrixes [2]. The photo methods as well as the imprint methods are parallel methods of storage and transfer of a giga- or terabit volumes of information. Until the present time there was no alternative for these methods before powerful computers that can store the same volumes of the information in the form of the integrated circuit topology have been got. At the same time the problem of defects of an "electronic mask" and its impurity during technological operations is completely eliminated. Thereby the prime cost of manufacturing of the electronic masks itself falls in million times and is commensurable with the cost of a DVD matrix. The computer plays a role of virtual "absolutely clean rooms". It also reduces the cost of a technological route by the cost of creation of "clean rooms" of the high class.

The following sequential nanolithography methods suitable for producing of quantum size electronic devises with extreme achievable operating parameters are known.

WO 01/71778 A2 discloses a method of depositing atoms of molecules in a predetermined pattern onto a surface by means of coherently controlled optical focusing of a beam of the atoms or molecules. The method consists of the steps of providing a collimated beam of atoms or molecules to be deposited, directing the beam through a first electromagnetic field typically produced by a laser beam, operative to produce a superposition of states of the atoms or molecules, and thereafter directing the beam through a second electromagnetic field, typically produced by two or more standing waves, such that the atoms or molecules are focused onto the surface in the predetermined pattern.

I.W. Rangelow et al. ""Nanojet": Tool for the nanofabrication", Journal of Vacuum Science and Technology B, Vol. 19, No. 6, November 2001, pages 2723 - 2726, discloses a scanning micro/nanonozzle. Electrically neutral radicals created in a plasma discharge are pumped through a small tube tapered to a nozzle. A small distance between the nozzle and the surface of the substrate allows a localized interaction. A strongly localized etching or deposition is thereby induced due to the high directionality of the molecular beam imaging from the high aspect ratio nanonozzle.

Similar scanning nanonozzle is also known from the publication of J. Voigt et al.: "Nanofabrication with scanning nanonozzle "Nanojet"", Microelectronic Engineering, Vo. 57-58, September 1, 2001, pages 1035 - 1042.

In [3] has been shown that in order to obtain low voltage (0.2-0.3 V) single-electron transistors the distance between conductors should be not less than 7,25 nm. Thus, the developing of a lithographic technology with resolution less than 7,25 nm has no physical sense.

The main unit of sequential nanotechnological apparatuses is a nanoreactor in which local physicochemical processes in the nanometer range take place under the influence of a probe energy. The probe itself scans sequentially (line by line) a surface. The scanning is realized either by a magnetic field in the case of the nanometer electronic or the ion beams or mechanically as scanning microscopes STM, AFM, or as a scanning optical near-field microscope (SNOM).

The using of the electronic or the ion beams for the scanning allows obtaining a large field of view up to square centimeters. Theoretically, the resolution of such a beam is determined by de Broigle wavelength of a particle. For example, the 150 eV electron gives the 0.1 nm resolution. But in practice the resolution achieved for a scanning electron microscopy is 5-10 nm only and is reached at the electron beam energy 100 keV. That is attributed to the fact that the electronic and the ion beams represent "gaseous" jets with high Coulomb repulsive forces that do not allow achieving the high density of a beam. The difficulty of such beams focusing results is the impossibility to create a high current in the beam (low brightness), and therefore a low efficiency takes place. Besides that because of a carrier's accumulation the activity with them needs an electro-conductive substrate. Thus, because of the low efficiency, more than one hour, the scanning with help of the electronic and ion beams can be used in nanolithography for manufacturing of master templates only. Moreover, the high energy of focused electrons leads to a considerable destruction of used materials that limits a spatial resolution of the method. An advantage is the capability of a direct observation (a monitoring) of the manufacturing process of a template in different power ranges with help of secondary electrons or photons.

The using of methods of a scanning tunnel microscopy for the nanolithography allows obtaining bright enough (high-current) electron sources for carrying out of local chemical reactions and for receiving the high resolution less than 0,1 nm. But here there are other problems. In essence, the chemical reactions are carried out sequentially with separate atoms or molecules and the time of each reaction is 10⁻⁸-10⁻⁹ seconds. Due to that the creation of one pixel of a figure with the size 14.5×14.5 nm requires 2·10⁻⁴ seconds. In such a case the scanning of merely 1 cm² with a number of pixels 4.7·10¹¹ requires some months of the continuous work. Because of the using of mechanical scanning systems based on the piezoceramic the view area is measured in 10-100 µm² only. Moreover, because of a mechanical hysteresis of the piezoceramic it is impossible to return a probe needle of the microscope to the start point that causes a superposition problem. Similar problems have AFM and SNOM. Moreover, the monitoring in these systems is carried out after the manufacturing of the topological figure that complicates and elongates all process considerably.

As it follows from said above, there is a number of problems for sequential ways of the nanolithography, which should be solved to make possible the creation of the serial apparatus.

In the considered invention a conjugation of wide known operation principles of the following devices as prototypes is used: a jet printer forming the figure with help of ink drops while the page scanning, a scanning electron microscope scanning by a narrow electron beam along large areas, devices for electrical control of the spatial structure of narrow-band light beams. However, these devices are not suitable for the nanolithography.

### Summary of the Invention.

The object of the scanning jet nanolithograph invention is to increase the scanning area up to 1-10 cm² together with the increase of the productivity up to 1-10 min per topological figure layer of the integrated circuit with a resolution of no less than 7,25 nm and the realization of the possibility of observation and monitoring of the manufacture process in real time.

One possible solution is the using of liquid jets of few nanometers in diameter [4-5]. However, numerical calculations of a nanojet motion in [5] show that the jets are widen and break along the distance at their way out from the capillary, that makes their use being difficult on long distances from a substrate. Moreover, it is difficult to form nanojets consisting of a chemically active substance preventing its chemical reactions with walls of a nozzle, since covering these walls with aurum does not give proper efficiency [5].

To form a liquid non-breaking nanojet being able to move in the vacuum at a distance of 10 cm from the nozzle and being able to scan an area of 1-10 cm² one should take into consideration all factors that affect the nanojet during its motion in the capillary and its exit to the vacuum [6].

It is known that under the atmosphere pressure nano-scale bubbles appear in the liquid [7]. The motion of the bubbles can cause non-stationary effects, namely a decay of the jet and cavitation processes on the substrate surface at a jet hitting point. That can result in uncontrolled processes and defects while the creation of the topological figure. The capillary pressure in the bubstone is defined by the relationship *P* = σ/2π*r_{b}*, where σ is a surface tension coefficient and *r*_{b} is a bubstone radius. For example, for the water under normal conditions this pressure equals *P*= 1,57 MPa. By increasing of the external pressure up to about 1,6 MPa the bubstones disappear. Therefore to form the homogeneous liquid nanojet it is necessary to apply the pressure at least 1,6 MPa [8].

A condition of the stability of the jet at the capillary exit can be derived from a ratio of a surface tension coefficient σ to a dynamical viscosity η. The critical speed of dielectric liquids when they flow still laminar does not exceed *ν_{cr}* = σ/η. This value for water equals 72 m/s. Experiments show that it is possible to form a long stable jet by taking into consideration this critical speed only [9]. In [4] the jet speed under consideration was 400 m/s that is greater by a factor of ten than the critical speed. That was the main reason why the obtaining of the stable jet was impossible for them.

The process of the topological figure creation implies either an application of a substance on a substrate or etching the substrate itself. And for drawing a pattern on several substrates a wide class of materials is needed, e.g. conductors, semiconductors, dielectrics. For etching one uses the chemically active substances that are special for each substrate material. Thus, it is necessary to find a way allowing the minimal touching of the active substance with the capillary walls.

Taking into account all factors described above which affect on the nanojet while it moves in the capillary and at the exit to the vacuum we propose the following method of the nanojet creation [6].

The liquid under the pressure required for a collapse of the bubstones is injected into a convergent hollow fiber made from the melted quartz glass, whereas a laser beam is introduced into walls of this fiber. The convergent capillary allows the light energy to be concentrated in a liquid activation zone namely in a capillary nozzle. The laser exerts the radiation pressure on the substance and prevents its contact with the walls. In [10] the ways of formation of the laser beams with the specified spatial structure are shown. The fiber is covered with a metal film in order to confine the light in the fiber. The pressure generated by photons will be determined by an absorption cross section of atoms. The maximal light pressure is generated by resonance absorption. The resonance pressure force on an atom *F* is estimated as an impulse transferred by photons flux with density *N* in the time unit: *F* = *Nℏkϑ*, where ℏ*k* = 2π ℏ / λ is an impulse of one photon, ϑ ≈ λ² is a resonance photon absorption cross section, λ is light wavelength. At saturation the radiation pressure force cease to depend on the intensity and is determined by the spontaneous decay rate. For typical values of the spontaneous decay rate about 10⁻⁸ s and light wavelength about 0,6 nm one can obtain *F* ≈ 5·10⁻³ eV/cm. For a standing laser wave the light pressure is defined by an effect of the spatial inhomogeneous field on an atomic dipole induced by it. The maximal pressure light force by the order of magnitude equals *F* ≈ *Ekd ,* where *d* is an atomic dipole moment. For values of *d*≈1 D, λ≈0,6µm, *E*≈10⁶ V/cm, the force *F* ≈ 5 ·10² eV/cm. If one generates in the resonator two or more standing waves with a small detuning, it will be able to control a direction of atoms motion by changing of this detuning, i.e. there is a possibility to control the jet - to turn it in the space.

E.g., as an operating substance any hydrocarbon can be taken. By breaking the chemical C-H bond we form radicals that are very chemically active. To break this bond one needs 4,28 eV, i.e. a radiation wavelength of 289 nm. One can use semiconductor lasers (second harmonic generation or regime of two-photon molecule excitation) to reduce the device cost. Such a radiation is intended to repel the liquid from the wall. It is possible to generate radicals needed for the nanolitograthy pattern creation at the fiber exit. The jet speed should be selected in such a way that a molecule has to have time to absorb a photon, but cannot have time to react with other molecules. For the absorption time 10⁻⁹ to 10⁻⁸ sec of order in the presented configuration the jet speed equals 10 to 100 m/sec, but it should not exceed the critical velocity by which the liquid continues the laminar motion or it will be necessary to form the jet from separate spherical drops. The radiation is enough to break most of C-H bonds amounts to 10⁶ - 10⁷ W/cm². The pressure generated of this radiation can amount up 5 GPa, which value does not exceed the fiber breaking strength at stretching.

During the exit of the nanojet from the nozzle the surface tension together with the radial force generated by the recoil impulses of the photons reradiated by molecules create the spatially steady jet. The time control of the jet can be performed by the duration of the laser impulse and also it is possible to generate the jet in the form of the drops. The capillary pressure of a liquid drop at the exit of the nozzle *Pₛ* = 2σ/*rₛ* will serve as a natural gate, where *rₛ* is a radius of the nozzle. For example, for the water by *rₛ*=7.25 nm the capillary pressure on the edge of the nozzle is *P*ₛ≈20 MPa.

The electromagnetic field generated in the near wave zone at the exit of the fiber will prevent the divergence of the nanojet. To realize the spatial space scanning of the nanojet on the substrate it is necessary to use two or four lasers with small frequency detuning. Due to a phase and an amplitude modulation it is possible to form a nonsymmetrical field deflecting the jet.

### The essence of the invention

The invention provides a scanning jet nanolithograph, as defined by claim 1, and a method of operating said scanning jet nanolithograph, as defined in claim 8.

The invention is shown in details on figures
Fig.1. A scheme of a scanning jet nanolithograph.
Fig.2. A structure of a capillary nozzle.
Fig.3. A Scheme of cutting of a silicon boule with nanojets.
Fig.4. A scheme of atomic grinding and drawing of monolayers during the creation of ultraviolet reflective optics with the nanojets.

### Brief description of the drawings

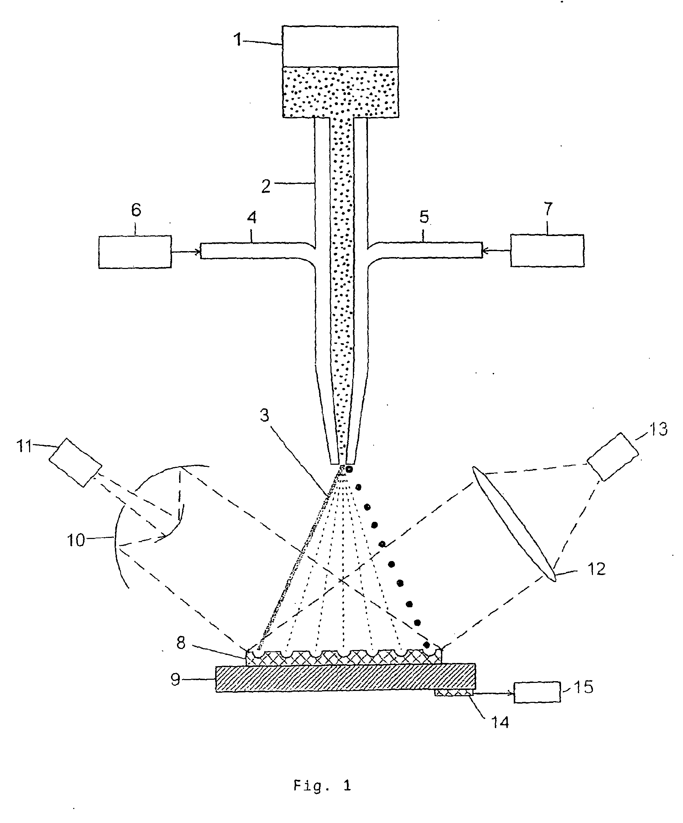

On Fig.1 the scheme of the scanning jet nanolithograph is presented. Here, 1 - a reservoir with the liquid under the pressure. The liquid comes through the convergent fiber 2 to the nozzle, which forms the nanoscaled jet 3. At the same time two optical signals formed by the electrically controlled narrow-band radiation sources 6, 7 are supplied to the nozzle by the waveguides 4, 5. The spatially non-homogenous electromagnetic field is formed at the end of the nozzle by the electrical modulation of optical signals from the sources 6, 7, wherein the electromagnetic field realizes the precise spatial scan of the jet 3 in xy plane along the substrate. The substrate is placed on a mechanically movable table 9 that realizes the less accurate displacement in the plane xy. The jet 3 realizes etching and/or drawing of a lithographic figure on the substrate 8. The monitoring of the lithographic process is realized in different spectral ranges from the sound range until the ultraviolet one. The signal arises in the contact zone between the substrate and the jet as a result of a mechanical impact and chemical reactions. The signal within the range from infrared to ultraviolet is detected by reflective optics 10 and a detector 11 corresponding to this range or in the optical range by a wide-angle optical system (lens system) 12 and a corresponding detector 13. To detect an acoustic signal one use an acoustic converter 14 acoustically joined with the substrate, a signal of which converter is detected by an acoustic detector 15. The information from the detectors is processed by a computer and displayed on a monitor.

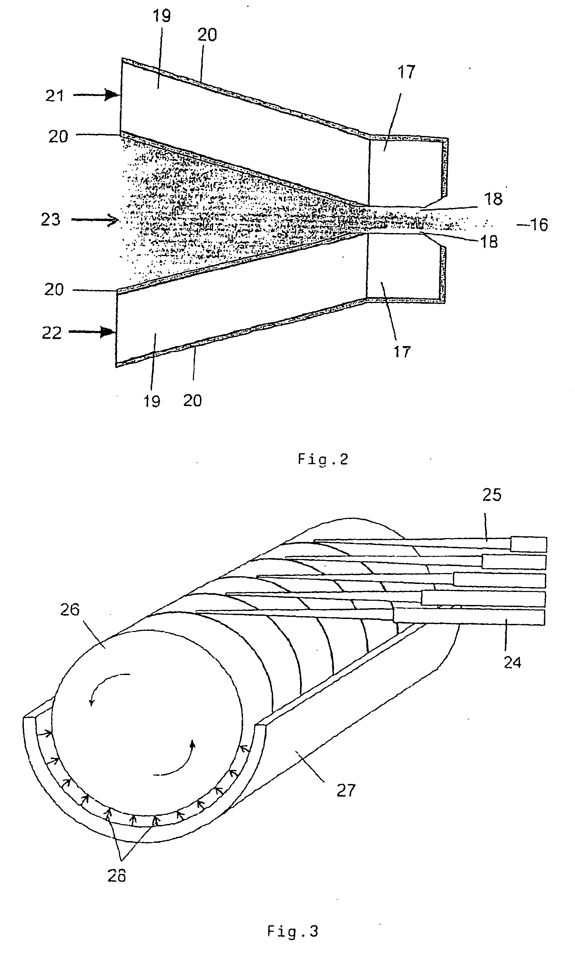

On Fig.2 the structure of the capillary nozzle is presented. Here, the formation of the jet 16 in the zone of the capillary nozzle 17 is shown. The nozzle 17 is an optical resonator, wherein length of which is divisible by half wavelength of the optical radiation introduced into the nozzle walls. The optical radiation generates the uniform radiation pressure on the jet 16 that moves away from the walls of the nozzle 17 and forms a gap 18 insulating from the walls. The convergent optically transparent capillary 19 is coated by a metallic reflecting coating 20, which at the same time realizes the chemical protection of the capillary. The modulated optical radiation 21, 22 and the active substance 23 under pressure are introduced into the capillary.

On Fig.3 the scheme of cutting of the silicon boule with the nanojets is presented. Here, the jets of the active substance are delivered on the processed material 26 with help of a paraiiei set of capillary nozzles 24. The silicon boule, a glass etc. can be used as the processed material. The substance of the jet is chosen as to realize the etching of the processed material with the gaseous waste generation. For elimination of vibrations the processed material 26 is placed at a special profile table 27 on a gas blanket 28. The gas blanket 28 is generated as to produce a driving torque.

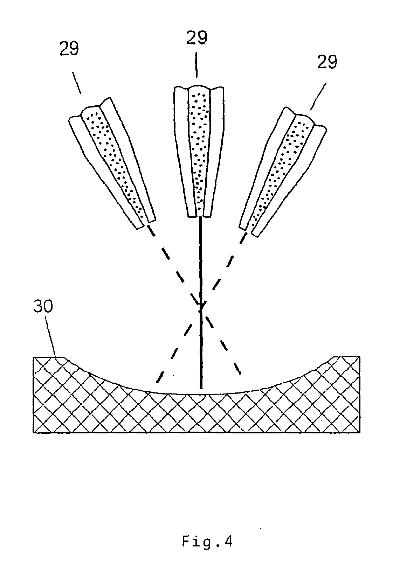

On Fig.4 the scheme of atomic grinding and drawing of the monolayers during the creation of the ultraviolet reflective optic with the nanojets is presented. Here, with the help of a set of nozzles 29 the jets of different active substances are consequently supplied for profile processing of a substrate 30. At first one realizes the etching, then the atomic grinding and the drawing of the atomic layers.

### Embodiment examples of the invention.

The claimed invention offers an opportunity of increasing of the scan area to 1-10 cm² with increasing the productivity up to 1-10 min for producing of one layer of the integrated circuit topological figure with the extreme resolution 5-7 nm. Thereby there is a possibility for the observation and the monitoring of the manufacture process in real time.

However, there is a question whether now presented technologies can be used for the production of the considered jet nanolithograph and whether the nanolithograph will be profitable for the integrated circuits mainstream production with the extreme resolution 5-7 nm.

Let's consider possibilities of the technical realization.

Let us calculate the possible productivity of a nanolithography apparatus based on the nanojet. The hydrocarbon is considered (e.g.) as a work liquid. Let us set the jet speed to be 50 m/s, its diameter - 14,5 nm, the distance between elements of the topological figure equals 7,25 nm. The topological figure is presented in the form of lines having 1 cm in length and 14,5 nm in width and 7,25 nm in the distance between the lines. Then the maximum density of pixels having 14,5 nm in size is 3,17·10¹¹ per cm². The maximum time modulation frequency of the jet is 3,45·10⁹ Hz, the maximum frequency of the lines in a frame 4,6·10⁵ Hz. The time of drawing is 1,5 min per cm². Then, a silicon plate with the diameter 30 cm will be treated during 17 hours.

The processing rate for existing serial lithography apparatus of 65 nm Twinscan XT: 1250 is 114 plates per hour.

Taking into account that our resolution is ten times higher, the density of elements is hundred times higher. If one compares the number of elements placed on the surface, the productivity of our apparatus in 20 times lower. The number of processing plate decreased in about 2000 times. But the prime cost of apparatus is in 20-100 times lower.

Advantages of the considered nanolithograph:
- An absence of a photo-template, the template is saved in the computer memory.
- Reducing of the number of technological operations of putting a photoresist on a substrate.
- Reducing of the number of monitoring operations on a technological route.
- Reducing of the human factor effect due to reducing of the route length.
- Reducing of the area of ultra-pure rooms.
- Reducing of the number of the layers on the substrate due to simplifying the elements base.
- Significant reducing of the apparatus prime cost in comparison with EUVL apparatus.
- A possibility to manufacture templates for EUVL apparatus.
- A possibility to manufacture templates for the imprint lithography.
- A possibility to use the apparatus as a high-resolution microscope for observing of dielectric and conductive objects without their destruction.

### Literature

1. R.P. Seisyan, "Extreme ultraviolet nanolithography for ULSI: A review," Technical Physics. 75, pp. 535-545, 2005.
2. Yong Chen, Douglas AA Ohlberg, Xuema Li, Duncan R. Stewart at al. Nanoscale molecular-switch devices fabricated by imprint lithography. Applied Physics Letters March 10, 2003 -- Volume 82, Issue 10, pp. 1610-1612.
3. Ilyanok, A.M. (2003) Quantum-Size Electronic Devices and Operating Conditions Thereof. US Patent 6,570,224,B1
4. Moseler M. and Landman U., Formation, Stability, and Breakup of Nanojets, Science 2000 289: 1165-1169.
5. Eggers J., Dynamics of liquid nanojets, Phys. Rev. Lett. 89, 084502 (2002)
6. Timoshchenko I.A., Ilyanok A.M. Formation of nanojet of radicals for nanolithography purposes. International Congress of Nanotechnology. November 1-3, 2005. San Francisco.
7. 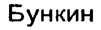 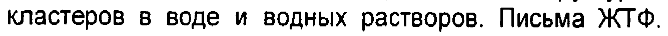 H.φ., 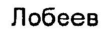 A.B. 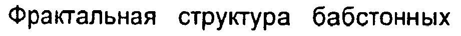 1993, 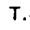 .58, 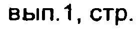
8. Mechanika razrushenia zhidkosti. Proc. Institute of Hydrodynamics. Novosibirsk, 1992. Vol. 104, pp.19, 22, 26, (1992) (In Russian).
9. Bologa M.K. Rabotaet pustota. Chisinau 1985, pp. 18.
10. I.A. Timoshchenko. Design of vectorial light beam in free space, in Proc. of IV International conference of young scientists Optics-05, p. 398 (October 17-21, 2005, St.-Petersburg, Russia)

## Claims

1. A scanning jet (3, 16) nanolithograph comprising at least one electrically controlled narrow band source (6, 7) of an optical radiation (21, 22) and one or more nozzles (17) each for generating a controlled jet (3, 16) from a chemically and/or physically active substance, which jet (3, 16) forms a figure on a substrate (8) and/or realizes a profile cutting of a processed material, **characterized in that** each one of the one or more nozzles (17) is an optical resonator and is made an optically transparent capillary (2), walls of which are provided for introducing the electrically controlled narrow band optical radiation (21, 22), wherein wavelength of the optical radiation is to provide a maximal symmetrical and/or nonsymmetrical light pressure on the substance flushed through the capillary (2) wherein a nozzle external size is not less than the wavelength of the used optical radiation.

2. The nanolithograph according to claim 1, **characterized in that** the substance flushed through the capillary (2) can be a gaseous, a liquid, a radical, a plasma one or its combination.

3. The nanolithograph according to claim 1, **characterized in that** the inner profile of the nozzle capillary (2) has a specified form.

4. The nanolithograph according to any of the claims 1-3, **characterized in that** the optically transparent capillary (2) has an inner diameter of no less than 5 nm.

5. The nanolithograph according to any of the claims 1-4, **characterized in that** the optically transparent capillary (2) is convergent to the nozzle (17) and is coated by a light reflecting coating (20) except the inner part of the capillary of the nozzle (17).

6. The nanolithograph according to any of the claims 1-5, **characterized by** the possibility of a relative displacement of at least one nozzle (17) and the substrate (8).

7. The nanolithograph according to any of the claims 1-6, **characterized by** an additional wide-angle optical system (10, 12) with detectors (11, 13) for collecting optical radiation within the range from infrared to ultraviolet, which optical radiation is arisen in a contact zone between the jet (3, 16) and an object.

8. The method of operating the nanolithograph according to any of the claims 1-7, **characterized in that** a spatial control of the jet (3, 16) is realized by a generation of a non-homogenous light pressure on the jet (3, 16) in the capillary of the nozzle (17), resulting in a specified deflection of the jet (3, 16) from a central axis at the exit of the capillary of the nozzle (17) and/or by time interruption of the light pressure.

9. The method of operating the nanolithograph according to claim 8, **characterized in that** the non-homogenous light pressure on the jet (3, 16) in the capillary is generated by a spatial phase or an amplitude shift of the optical radiation from at least one electrically controlled narrow band source (6, 7).

10. The method of operating the nanolithograph according to claims 8 or 9, **characterized in that** a spatial interruption of the jet (3, 16) is realized by switching off the optical radiation.

11. The method of operating the nanolithograph according to any of the claims 8 to 10, **characterized in that** a pressure of a liquid supplied to the capillary (2) is chosen as to be greater than a bubstones formation pressure for this liquid, but lower than a capillary pressure at the exit of the nozzle (17).

12. The method of operating the nanolithograph according to any of the claims 8 to 11, **characterized in that** during the cutting of the processed material the spatial control of the cutting is realized at least by an optical control of the jet (3, 16) or the jets (3, 16) as well as by a mechanical displacement of the processed material and/or the one or more nozzles (17).

13. The method of operating the nanolithograph according to claim 8, **characterized in that** the posterior conversion of the optical radiation in the contact zone between the jet (3, 16) and an object into an electrical signal intended for the computer processing is used for monitoring the formation of a topological figure on the substrate (8) or for cutting the processed material.

## Patentansprüche

1. Nanolithografievorrichtung mit Abtaststrahl (3, 16), umfassend
- mindestens eine elektrisch gesteuerte Schmalbandquelle (6, 7) einer optischen Strahlung (21, 22) und
- eine oder mehrere Düsen (17), jede zur Erzeugung eines gesteuerten Strahls (3, 16) von einer chemisch und/oder physikalisch aktiven Substanz,
- wobei der Strahl (3, 16) eine Figur auf einem Substrat (8) bildet und/oder ein Profilschneiden eines verarbeiteten Materials verwirklicht,
**dadurch gekennzeichnet, dass** jede der einen oder mehreren Düsen (17) ein optischer Resonator ist und aus einer optisch transparenten Kapillare (2) hergestellt ist, wobei Wände von dieser zur Einführung der elektrisch gesteuerten optischen Schmalbandstrahlung (21, 22) vorgesehen sind, wobei eine Wellenlänge der optischen Strahlung derart ist, dass sie einen maximalen symmetrischen und/oder nichtsymmetrischen Lichtdruck auf die durch die Kapillare (2) gespülte Substanz bereitstellt, wobei eine äußere Größe einer Düse nicht geringer als die Wellenlänge der verwendeten optischen Strahlung ist.

2. Nanolithografievorrichtung nach Anspruch 1, **dadurch gekennzeichnet, dass** die durch die Kapillare (2) gespülte Substanz gasförmig, eine Flüssigkeit, ein Radikal, ein Plasma oder eine Kombination daraus sein kann.

3. Nanolithografievorrichtung nach Anspruch 1, **dadurch gekennzeichnet, dass** das Innenprofil der Düsenkapillare (2) eine spezifizierte Form aufweist.

4. Nanolithografievorrichtung nach einem der Ansprüche 1 - 3, **dadurch gekennzeichnet, dass** die optisch transparente Kapillare (2) einen Innendurchmesser von nicht weniger als 5 nm aufweist.

5. Nanolithografievorrichtung nach einem der Ansprüche 1 - 4, **dadurch gekennzeichnet, dass** die optisch transparente Kapillare (2) zu der Düse (17) konvergierend ist und mit Ausnahme des Innenteils der Kapillare der Düse (17) mit einer lichtreflektierenden Beschichtung (20) überzogen ist.

6. Nanolithografievorrichtung nach einem der Ansprüche 1 - 5, **gekennzeichnet durch** die Möglichkeit einer relativen Verschiebung mindestens einer Düse (17) und des Substrats (8).

7. Nanolithografievorrichtung nach einem der Ansprüche 1 - 6, **gekennzeichnet durch** ein zusätzliches optisches Weitwinkelsystem (10, 12) mit Detektoren (11, 13) zum Sammeln optischer Strahlung innerhalb des Bereichs vom Infraroten bis zum Ultravioletten, wobei die optische Strahlung in einer Kontaktzone zwischen dem Strahl (3, 16) und einem Objekt entstanden ist.

8. Verfahren zum Betrieb der Nanolithografievorrichtung nach einem der Ansprüche 1 - 7, **dadurch gekennzeichnet, dass** eine räumliche Steuerung des Strahls (3, 16) durch Erzeugung eines nichthomogenen Lichtdrucks auf den Strahl (3, 16) in der Kapillare der Düse (17), was zu einer spezifizierten Ablenkung des Strahls (3, 16) von einer Mittelachse am Ausgang der Kapillare der Düse (17) führt, und/oder durch zeitliche Unterbrechung des Lichtdrucks verwirklicht wird.

9. Verfahren zum Betrieb der Nanolithografievorrichtung nach Anspruch 8, **dadurch gekennzeichnet, dass** der nichthomogene Lichtdruck auf den Strahl (3, 16) in der Kapillare durch eine räumliche Phase oder eine Amplitudenverschiebung der optischen Strahlung von mindestens einer elektrisch gesteuerten Schmalbandquelle (6, 7) erzeugt wird.

10. Verfahren zum Betrieb der Nanolithografievorrichtung nach Anspruch 8 oder 9, **dadurch gekennzeichnet, dass** eine räumliche Unterbrechung des Strahls (3, 16) durch Abschalten der optischen Strahlung verwirklicht wird.

11. Verfahren zum Betrieb der Nanolithografievorrichtung nach einem der Ansprüche 8 bis 10, **dadurch gekennzeichnet, dass** ein Druck einer der Kapillare (2) zugeführten Flüssigkeit so gewählt wird, dass er größer als ein Bubstone-Bildungsdruck für diese Flüssigkeit, aber niedriger als ein Kapillardruck am Ausgang der Düse (17) ist.

12. Verfahren zum Betrieb der Nanolithografievorrichtung nach einem der Ansprüche 8 bis 11, **dadurch gekennzeichnet, dass** während des Schneidens des verarbeiteten Materials die räumliche Steuerung des Schneidens mindestens durch eine optische Steuerung des Strahls (3, 16) oder der Strahlen (3, 16) sowie durch eine mechanische Verschiebung des verarbeiteten Materials und/oder der einen oder mehreren Düsen (17) verwirklicht wird.

13. Verfahren zum Betrieb der Nanolithografievorrichtung nach Anspruch 8, **dadurch gekennzeichnet, dass** die spätere Umwandlung der optischen Strahlung in der Kontaktzone zwischen dem Strahl (3, 16) und einem Objekt in ein für die Computerverarbeitung bestimmtes elektrisches Signal zur Überwachung der Bildung einer topologischen Figur auf dem Substrat (8) oder zum Schneiden des verarbeiteten Materials verwendet wird.

## Revendications

1. Appareil de nanolithographie à jets de balayage (3, 16) comprenant au moins une source en bande étroite à commande électrique (6, 7) d'un rayonnement optique (21, 22) et une ou plusieurs buse(s) (17) chacune pour générer un jet (3, 16) commandé d'une substance chimiquement et/ou physiquement active, lequel jet (3, 16) forme un motif sur un substrat (8) et/ou réalise un profilage d'une matière usinée, **caractérisé en ce que** chacune de l'une ou plusieurs buse(s) (17) est un résonateur optique et est faite d'un capillaire (2) optiquement transparent, des parois duquel sont prévues pour introduire le rayonnement optique (21, 22) en bande étroite à commande électrique, dans lequel une longueur d'onde du rayonnement optique vise à appliquer une pression de lumière maximale symétrique et/ou non symétrique sur la substance chassée à travers le capillaire (2), dans lequel une taille externe de buse n'est pas inférieure à la longueur d'onde du rayonnement optique utilisé.

2. Appareil de nanolithographie selon la revendication 1, **caractérisé en ce que** la substance chassée à travers le capillaire (2) peut être une substance gazeuse, liquide, radicalaire, ou plasmatique, ou une combinaison de celles-ci.

3. Appareil de nanolithographie selon la revendication 1, **caractérisé en ce que** le profil intérieur du capillaire (2) de buse a une forme spécifiée.

4. Appareil de nanolithographie selon l'une quelconque des revendications 1 à 3, **caractérisé en ce que** le capillaire (2) optiquement transparent a un diamètre intérieur de pas moins de 5 nm.

5. Appareil de nanolithographie selon l'une quelconque des revendications 1 à 4, **caractérisé en ce que** le capillaire (2) optiquement transparent est convergent vers la buse (17) et est revêtu d'un revêtement réfléchissant la lumière (20), à l'exception de la partie intérieure du capillaire de la buse (17).

6. Appareil de nanolithographie selon l'une quelconque des revendications 1 à 5, **caractérisé par** la possibilité d'un déplacement relatif d'au moins une buse (17) et du substrat (8).

7. Appareil de nanolithographie selon l'une quelconque des revendications 1 à 6, **caractérisé par** un système optique grand angle (10, 12) additionnel avec des détecteurs (11, 13) pour collecter un rayonnement optique dans la plage allant des infrarouges aux ultraviolets, lequel rayonnement optique apparaît dans une zone de contact entre le jet (3, 16) et un objet.

8. Procédé d'utilisation de l'appareil de nanolithographie selon l'une quelconque des revendications 1 à 7, **caractérisé en ce qu'**une commande spatiale du jet (3, 16) est réalisée par une génération d'une pression de lumière non homogène sur le jet (3, 16) dans le capillaire de la buse (17), résultant en une déflexion spécifiée du jet (3, 16) par rapport à un axe central à la sortie du capillaire de la buse (17) et/ou par une interruption temporelle de la pression de lumière.

9. Procédé d'utilisation de l'appareil de nanolithographie selon la revendication 8, **caractérisé en ce que** la pression de lumière non homogène sur le jet (3, 16) dans le capillaire est générée par une phase spatiale ou un décalage d'amplitude du rayonnement optique provenant d'au moins une source en bande étroite à commande électrique (6, 7).

10. Procédé d'utilisation de l'appareil de nanolithographie selon la revendication 8 ou 9, **caractérisé en ce qu'**une interruption spatiale du jet (3, 16) est réalisée par coupure du rayonnement optique.

11. Procédé d'utilisation de l'appareil de nanolithographie selon l'une quelconque des revendications 8 à 10, **caractérisé en ce qu'**une pression d'un liquide amené jusqu'au capillaire (2) est choisie pour être plus grande qu'une pression de formation de nanobulles (bubstones) pour ce liquide, mais plus petite qu'une pression capillaire à la sortie de la buse (17).

12. Procédé d'utilisation de l'appareil de nanolithographie selon l'une quelconque des revendications 8 à 11, **caractérisé en ce que** pendant la découpe de la matière usinée, la commande spatiale de la découpe est réalisée au moins par une commande optique du jet (3, 16) ou des jets (3, 16), ainsi que par un déplacement mécanique de la matière usinée et/ou de l'une ou plusieurs buses (17).

13. Procédé d'utilisation de l'appareil de nanolithographie selon la revendication 8, **caractérisé en ce que** la conversion postérieure du rayonnement optique dans la zone de contact entre le jet (3, 16) et un objet en un signal électrique destiné au traitement par ordinateur est utilisée pour surveiller la formation d'un motif topologique sur le substrat (8) ou pour la découpe de la matière usinée.
